# EUROPEAN PATENT SPECIFICATION

(11) **EP 0 450 381 B1**
(45) Date of publication and mention of the grant of the patent: **11.08.2004**
(21) Application number: 91104125.9
(22) Date of filing: 18.03.1991
(51) Int. Cl.: H01L 21/48

(54) **Multilayer interconnection structure**
Mehrschicht-Verbindungsstruktur
Structure d'interconnexion multi-couche

(30) Priority: 19.03.1990 JP 6913390
(43) Date of publication of application: 09.10.1991
(73) Proprietor: FUJITSU LIMITED, Kawasaki-shi, Kanagawa 211 (JP)
(72) Inventor: Satoh, Kazuaki, c/o FUJITSU LIMITED, Kawasaki-shi, Kanagawa 211 (JP)
(74) Representative: Sunderland, James Harry

(56) References cited:
- EP-A- 0 099 544
- EP-A- 0 346 617
- DE-A- 3 522 852
- 6TH IEEE/CHMT INTERNATIONAL ELECTRONIC MANUFACTURING TECHNOLOGY SYMPOSIUM 26 April 1989, NARA, JP pages 128 - 131; N. IWASAKI ET AL.: 'A pillar-shaped via structure in a cu-polyimide multilayer substrate'
- IBM TECHNICAL DISCLOSURE BULLETIN. vol. 20, no. 9, February 1978, NEW YORK US pages 3443 - 3444; M.M. HADDAD: 'Selectively electroplating pad terminals on an MLC substrate.'
- IBM TECHNICAL DISCLOSURE BULLETIN. vol. 32, no. 6B, November 1989, NEW YORK US pages 326 - 327; 'Additive plating on chromium for circuitizing non-epoxy substrates.'

## Description

The present invention relates to a method of fabricating multilayer structures, for example as employed in hybrid ICs (integrated circuits) or semiconductor devices, etc. More particularly, the present invention is concerned with the provision of reliable connections between electrically conductive layers insulated by an insulative layer therebetween.

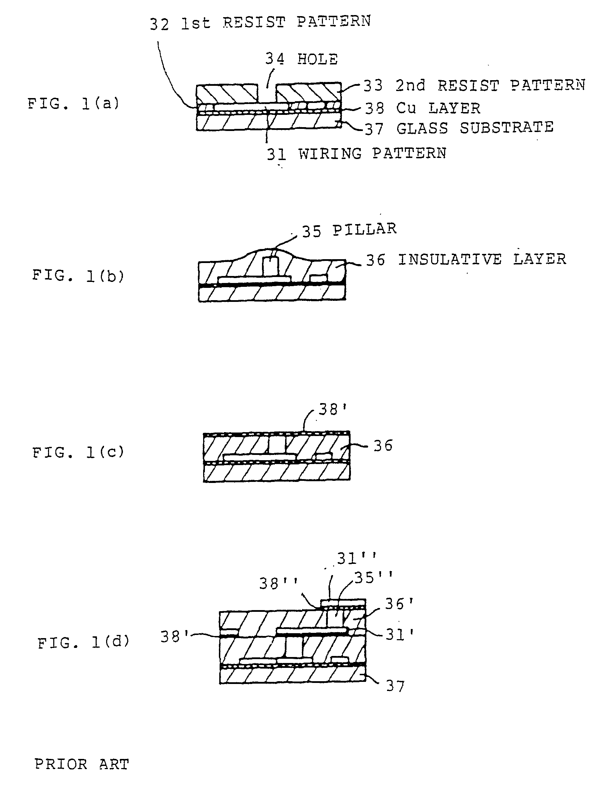

Many kinds of multilayer structure and methods of fabricating such structures, for example for hybrid ICs (integrated circuits) or semiconductor devices, have been proposed. A typical proposal is found in Japanese Unexamined Patent Publication Sho-63-244796 and shown in Figs. 1. In this proposed method, the following steps are employed:-
(a) forming a layer for a wiring pattern 31 on a first electrically conductive layer 38 on an insulative layer 37;
(b) forming thereon a first resist pattern 32, using which wiring pattern 31 is formed;
(c) forming on first resist pattern 32 a second resist pattern 33 having a hole 34 located above wiring pattern 31 (Fig. 1a), and forming a pillar 35 in hole 34 by electroplating;
(d) removing first and second resist patterns 32 and 33; then forming a polyimide resin layer 36 (Fig. 1b); and exposing a top of pillar 35 by polishing or etching the surface of the polyimide resin layer;
(e) forming a second electrically conductive layer 38' (Fig. 1c) and a second wiring pattern 31' (Fig. 1d) over polyimide resin layer 36 including the pillar top.

With this method, the top of the pillar is flat, as will be understood from the description of Fig. 1(b) and Fig. 1(c), where the pillar top is shown to be flat. It has been determined that, as a result, contact between the pillar and the electrically conductive layer 8 thereon is not strong enough to withstand mechanical stress caused by heat cycles, etc., resulting in the possibility of the connection breaking. Accordingly, the reliability of electrical connection between the multiple layers deteriorates. Moreover, if the pillar top is to be flattened by mechanically polishing the surface of insulative layer 36, the polishing is very difficult to accomplish because the substrate is subject to bending as a result of the polyimide resin coating.

6th IEEE/CHMT International Electronic Manufacturing Technology Symposium 26th April 1989, Nara, Japan, pages 128 - 131, "A pillar-shaped Via structure in a Cu-polyimide multilayer structure", discloses a method of fabricating a multilayer structure, comprising:-
(a) forming a first electrically conductive layering;
(b) providing a resist layer with a via hole, said via hole being located on said first electrically conductive layering;
(c) forming a via lead in said via hole by electrically plating a metal therein;
(d) removing said resist layer;
   and then
(e) forming a layer of photosensitive (polyimide precursor) material over said first electrically conductive layering and said via lead;
(f) selectively exposing the photosensitive material to light of differing exposure energies so as to render parts of the material selectively more or less soluble in developer, such that upon developing and curing the material is flattened and the top of the via lead uncovered; and
(g) forming a second electrically conductive layering over the cured material and the uncovered part of said via lead.

EP-0 099 544 discloses a method of fabricating an electrical interconnection package with a dielectric body having vias therein which form a planar surface with the dielectric body, in which method;-
(a) a blanket layer of conductive material is deposited on the planar surface.
(b) the layer of conductive material is delineated into a circuit pattern connected to the vias,
(c) an etch mask is formed on the surface of the circuit pattern to define where via studs are to be formed,
(d) unmasked areas of the circuit pattern are etched to reduce the thickness of the circuit pattern and to form via studs, and
(e) dielectric material, for example polyimide is deposited on the dielectric body,
(f) the dielectric material is lapped or RIE etched or plasma etched to provide a planar surface and to expose the top surface of the via studs.

US-A-4 917 759 and EP-A-0 329 960 disclose methods for forming metal vias or pillars in semiconductor devices, in which methods the via or pillar has an insulating or dielectric layer deposited thereover, which layer is then etched back to expose a portion of the via or the top of the pillar, and a conductive (aluminium) layer is then applied or deposited over the exposed via or pillar.

EP-A-0 324 198 discloses a method for making connections in an integrated circuit in which a conductive material is blanket deposited over an insulating layer and in sub-micron openings in the insulating layer. The conductive material is then etched away sufficiently to remove it from the upper surface of the insulating layer while leaving it as plugs in the openings. Then, etching is effected in which the insulating layer is etched more rapidly than the conductive material so as to form a new upper surface of the insulating layer lower than or substantially the same as the upper surfaces of the conductive material in the openings, Thereafter a further conductive material is deposited over those upper surfaces.

According to the present invention there is provided a method of fabricating a multilayer structure as set out in claim 1.

Embodiments of the present invention can provide multilayer structure fabrication methods which afford a reliable connection of two patterns isolated by an insulative layer therebetween.

Embodiments of the present invention can provide multilayer structure fabrication methods which afford improved flatness of each wiring pattern and allow a greater number of layers to be provided in a multilayer structure.

Reference is made, by way of exemple, to the accompanying drawings, in which:-
Figs. 1(a) to 1(d) are schematic sectional views illustrating fabrication steps in the production of a prior art multilayer structure; and
Figs. 2(a) to (q) are schematic sectional views illustrating fabrication steps in accordance with an embodiment of the present invention, and Fig. 2(q) schematically illustrates a completed three-layer structure in accordance with an embodiment of the present invention.

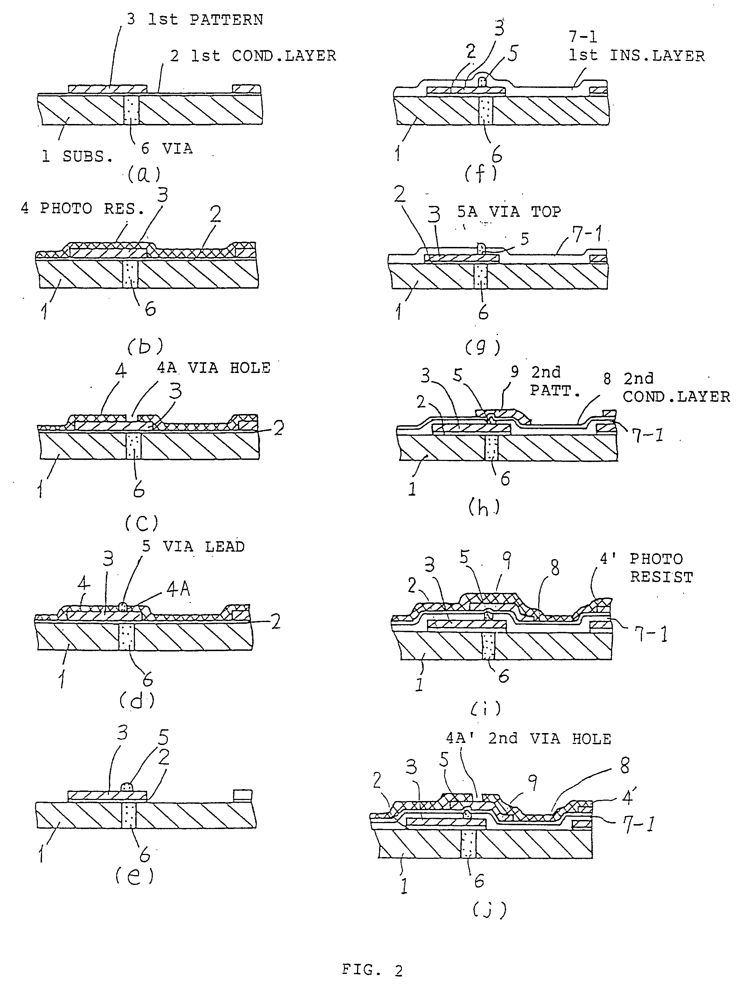

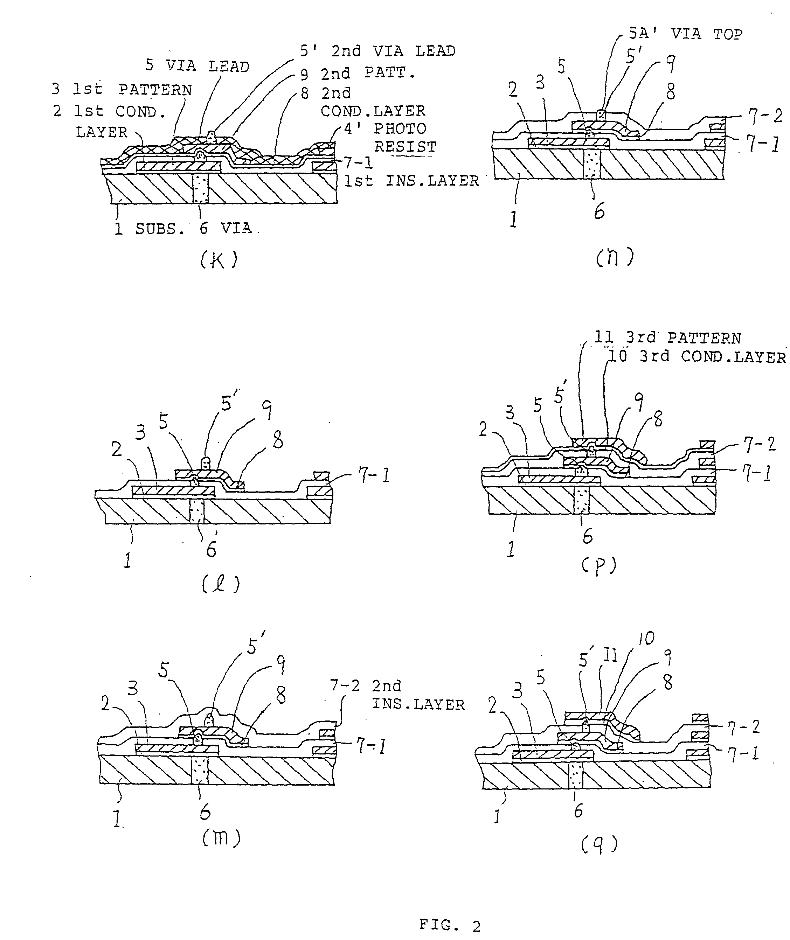

A method of fabricating a multilayer structure in accordance with an embodiment of the present invention is hereinafter described with reference to fabrication steps illustrated in Figs. 2.

A first electrically conductive layer 2 is formed upon a surface of an e.g. insulative substrate, for example a ceramic material substrate, by depositing electrically conductive material or materials, such as a 1500 Å thick chrome film, a 500 Å thick titanium film thereon and a 10000 Å thick copper film thereon. Next, an electrically conductive pattern 3 is formed thereon by depositing, for example, a 5 µm thick copper layer, a 2 µm thick nickel layer thereon and a 1500 Å chrome layer thereon using an electroplating process. In this electroplating process, first electrically conductive layer 2 can be utilised as a lead for the electroplating.

In this embodiment, ceramic substrate 1 has been provided in advance with a via 6 penetrating the substrate at a predetermined location, whereby pattern 3 is led out to the back of substrate 1 (step a - Fig. 2(a)).

Next, first electrically conductive layer 2 and first pattern 3 are coated with photo resist 4 of a predetermined thickness, for example, approximately 20 µm (step b - Fig. 2(b)).

A via hole 4A of approximately 80 µm diameter is formed/drilled at a predetermined location on the photosensitive resist 4, above the first pattern 3, for example by light exposure, developing and etching (step c - Fig. 2(c)).

Next, copper is electroplated to a thickness of approximately 25 µm in via hole 4A so as to form a via Lead therein. This electroplating process is carried out under carefully controlled plating conditions such that a brightener is added in the plating solution and the current density is typically 5 to 10 A/cm², so that an excellent levelling effect, a high tensile strength as well as a low electrical resistance are achieved (step d - Fig. 2(d)).

Next, photo resist 4 is removed, as is the first electrically conductive layer 2 except beneath first pattern 3 (step e - Fig. 2(e)).

Next, a non-photosensitive resin, such as polyamic acid resin, is coated upon substrate 1 and first pattern 3 with via lead 5 thereon. The thus-coated resin is heated at 350 to 450°C for 30 to 60 minutes, so that the resin is hardened to become polyimide resin, to provide a first insulative layer 7-1. Coating conditions, such as viscosity of the polyamic acid resin, are adjusted so that the coating thickness is approximately 22 µm over flat areas, and 0.5 to 0.8 µm over the top of the 25 µm tall via lead 5 (step f - Fig. 2(f)).

Next, the surface of first insulative layer 7-1 is removed by RIE (reactive ion etching) or an ion milling technique employing oxygen (O₂) and carbon tetrafluoride (CF₄) as etchants, until the top 5A of via lead 5 is exposed by as much as 3 to 5 µm above the surface of first insulative layer 7-1. During the etching process, the etchants do not react with the metal of via lead 5 (step g - Fig. 2(g)).

Next, a second electrically conductive layer 8 and a second pattern 9 are formed over first insulative layer 7-1 as well as the thus exposed via top 5A, in the same way as the first electrically conductive layer 2 and first pattern 3 were formed. Plating conditions can be chosen, in accordance with well-known techniques, so as to provide excellent adhesion therebetween as well as a levelling effect which results in less thickness being plated over the via top 5A than over flat areas. As a result, the surface of thus-formed second pattern 9 can be flat within -µm undulation (e.g. flat to about a micrometer) even over the 3 to 5 µm protrusion of via top 5A. Furthermore, the 3 to 5 µm protrusion of via top 5A provides a non-flat shape, which disperses stress generated at the contact border, as well as providing a wider area for contact with the pattern plated thereover than the flat top of pillar 35 of the prior art described above. Owing to the favourable via top shape and plating conditions, first pattern 3 and second pattern 9 are reliably connected by via lead 5 (step h - Fig. 2(h)).

Further, the polyamic acid resin first adheres to the via lead 5, and is then hardened by heat to become a polyimide resin. Thus, adhesion between the via lead and the resin is excellent. On the contrary, in the prior art structure described above where the via and the upper pattern are concurrently plated in a previously provided via hole of the insulative layer, there can be no adhesion between the via lead and the insulative layer.

Moreover, first insulative layer 7-1 need not be photosensitive. Accordingly, polyimide resin which has a thermal expansion coefficient substantially equal to that of via 5 can be employed, because there are available many kinds of non-photosensitive polyimide resins having various thermal expansion coefficients. Therefore, there is no longer the problem, which is encountered when a photosensitive polyimide resin is employed, of stress caused by the insulative layer 7-1 separating second pattern 9 from via Lead 5.

These above features, together with the above-described reliable connection between the via lead and the pattern, serve to prevent breakage of the connection between via and pattern, and accordingly contribute to enhanced connection reliability.

If a third pattern is to be fabricated over second pattern 9, the same processes as described above are repeated. That is, a photoresist 4' is coated all over second electrically conductive layer 8 and second pattern 9 (step i - Fig. 2(i)).

Next, a second via hole 4A' is etched out at a predetermined location on photoresist 4' (step j - Fig. 2(j)).

Next, copper is electroplated in second via hole 4A' to form a second via lead 5' on first pattern 9 by utilising second electrically conductive layer 8 as a lead of the electroplating (step k - Fig. 2(k)).

Next, photoresist 4' is removed, as is second electrically conductive Layer 8 except the beneath second pattern 4' (step L - Fig. 2(l)).

Next, polyamic acid resin is coated upon first insulative layer 7-1 and second pattern 9 thereon, and is heated to become polyimide resin as a second insulative layer 7-2 (step m - Fig. 2(m)).

Next, the surface of second insulative layer 7-2 is removed so as to expose 3 to 5 µm of the top 5A' of second via lead 5' (step n - Fig. 2(n)).

Next, a third electrically conductive layer 10 and a third pattern 11 are formed over second insulative layer 7-2 as well as thus-exposed via top 5A' (step p - Fig. 2(p)).

Next, third electrically conductive layer 10 is removed except beneath third pattern 11.

Thus, a multilayer structure having the second pattern connected to the first pattern, and the third pattern connected to the second pattern, by via leads 5 and 5' respectively, is shown in step q - Fig. 2(q).

If a fourth pattern is required, the above-described steps on and after step i - Fig. 2(i) - where electrically conductive layer 10 is not yet removed, are further repeated. By the repetition of the above-described steps, as many layers of patterns as required can be stacked, with no problem of reLiabiLity deterioration due to non-flat surfaces of the many layers, because the patterns are adequately flat even when plated on the via tops 5a and 5A'.

The thickness of each layer in Figs. 2 is exaggerated, and therefore the Figures do not show the real degree of flatness achieved.

In the above description it is indicated that the first, second and third patterns 3, 9 and 11 are formed of laminations of copper, nickel and chrome. However, it will be apparent that other structures and other materials can be used. For example, Au, Cr/Au lamination, or Cr/Pt lamination can be used. A chrome surface provides for excellent adhesion with polyimide resin.

In the above description it is indicated that the first, second and third electrically conductive layers 2, 8 and 10 are formed of layers of Cr, Ti/Cu lamination. However, it will be apparent that other structures and materials may be used. For example Ti/Cu lamination, Ti-W/Cu lamination or TaN-Cu lamination may be used.

In the above description first pattern 3 is indicated to be formed over first electrically conductive layer 2. It will be apparent, however, that first electrically conductive layer 2 may be contrarily formed over first pattern 3 formed directly on substrate 1, where the via lead of the invention is formed on first electrically conductive layer.

In the above description the first and second insulative layers 7-1 and 7-2 are indicated to be formed of polyimide resin. It will be apparent however that the insulative layers may be formed of other insulative materials, such as fluororesin.

In the above description the substrate is indicated to have a via 6 therein formed in advance. However, it will be apparent that a substrate having no via therein can be provided. On the other hand, the first pattern 3 and the via lead 5 may be formed by being electroplated by the use of the via 6 as a lead for the plating, where first electrically conductive layer 2 is not provided or is removed.

In accordance with an embodiment of the present invention, a multilayer structure is fabricated as follows:- a first conductive layer is formed on an e.g. insulative substrate; a first conductive pattern is formed thereon; a resist layer is formed thereon having a via hole on the first pattern; a via lead is formed in the via hole by electrically plating a metal therein utilising the first layer as a lead for the plating process; removing the resist and the exposed part of the first layer; forming a polyimide layer preferably having a thermal expansion coefficient equal to the material of the via lead all over the substrate; etching the surface of the polyimide layer until the via lead top protrudes a predetermined height from the surface of the etched polyimide layer; and forming a second pattern thereon by a plating process. The protruding portion of the via lead provides a relatively extensive area for contact and allows mechanical stresses at the contact border to disperse. A levelling effect afforded by appropriate plating conditions provides an adequately flat surface for the second pattern even above the protruding via lead top so that many layers can be stacked together without problems due to less flat surfaces. Good adherence of resin to the via lead, together with the provision of matched thermal expansion coefficients for the via lead and the resin, eliminate stress tending to separate the second layer from the via lead, enhancing reliability of the connection between the two patterns.

## Claims

1. A method of fabricating a multilayer structure, comprising:-
(a) forming a first electrically conductive layering (2, 3);
(b) providing a resist layer (4) with a via hole (4A), said via hole being located on said first electrically conductive layering;
(c) forming a via lead (5) in said via hole by electrically plating a metal therein;
(d) removing said resist layer (4);
(e) forming an insulative layer (7-1) of non-photosensitive material over said first electrically conductive layering (2, 3) and said via lead (5);
(f) etching a surface part of said insulative layer (7-1) until a top part of said via lead (5) protrudes by a predetermined height from the etched surface of said insulative layer; and
(g) forming a second electrically conductive layering (8; 8, 9) over said insulative layer (7-1) and over the protruding part of said via lead (5).

2. A method as claimed in claim 1, wherein said first electrically conductive layering is formed by:-
(a1) forming a first electrically conductive layer (2) on an insulative substrate (1),
(a2) forming a first electrically conductive pattern (3) on said first electrically conductive layer (2);
said resist layer (4) being formed over said first electrically conductive layer (2) and over said first electrically conductive pattern (3), said via hole (4A) being located on said first pattern (3);
said first electrically conductive layer (2) being utilised as a lead for said plating to form said via lead (5);
and wherein a predetermined part of said first electrically conductive layer (2) is removed before the forming of said insulative layer (7-1) which is coated all over said substrate (1), said first electrically conductive pattern (3) and said via lead (5).

3. A method as described in claim 1, wherein said first electrically conductive layering is formed by:-
(a1) forming a first electrically conductive pattern on an insulative substrate having a via, said via electrically connecting both sides of said substrate;
said resist layer being formed over said substrate and over said first electrically conductive pattern, said via hole being located on said first pattern;
said via in the substrate being utilised as a lead for said plating;
said insulative layer being coated all over said substrate, said first electrically conductive pattern and said via lead.

4. A method as claimed in claim 1, wherein said first electrically conductive layering is formed by:-
(a1) forming a first electrically conductive pattern on an insulative substrate;
(a2) forming a first electrically conductive layer on said first electrically conductive pattern;
said resist layer being formed over said first electrically conductive layer, said via hole being located on said first pattern;
said first electrically conductive layer being utilised as a lead for said plating to form said via lead;
and wherein a predetermined part of said first electrically conductive layer is removed before the forming of said insulative layer which is coated all over said substrate, a residual part of said first electrically conductive layer and said via lead.

5. A method as claimed in any preceding claim, wherein said insulative layer (7-1) is formed of a resin, for example an organic resin.

6. A method as claimed in any preceding claim, wherein said insulative layer is polyimide.

7. A method as claimed in any preceding claim, wherein said insulative layer has a thermal expansion coefficient substantially equal to thermal expansion coefficient of the material of said via lead.

8. A method as claimed in any preceding claim, wherein said insulative layer is formed substantially thinner on top of said via lead than on other, flat portions.

9. A method as claimed in any preceding claim, wherein the surface part of said insulative layer is removed by a chemical etching.

10. A method as claimed in any preceding claim, wherein the surface part of said insulative layer is removed by a reactive ion etching method or an ion milling method.

11. A method as claimed in any preceding claim, wherein said second electrically conductive layering is an electrically conductive pattern, formed for example by electrical plating.

12. A method as claimed in any preceding claim, further comprising:-
forming a further insulative layer (7-2) over said second electrically conductive layering (8; 8, 9) and said insulative layer (7-1),
repeating said steps (a) to (g) to provide a structure on said second insulative layer (7-2), which acts as an insulative substrate in the repeat steps.

## Patentansprüche

1. Verfahren zur Herstellung einer Mehrschichtstruktur, welches umfasst:
(a) Bilden einer ersten elektrisch leitenden Schicht (2, 3);
(b) Bereitstellen einer Resist-Schicht (4) mit einem Durchgangsloch (4A), welches auf der ersten elektrisch leitenden Schicht angeordnet ist;
(c) Bilden einer Durchgangsleitung (5) im Durchgangsloch durch elektrisches Plattieren eines Metalls darin;
(d) Entfernen der Resist-Schicht (4);
(e) Bilden einer isolierenden Schicht (7-1) aus nicht-lichtempfindlichem Material über der ersten elektrisch leitenden Schicht (2, 3) und der Durchgangsleitung (5);
(f) Ätzen eines Oberflächenteils der isolierenden Schicht (7-1) bis ein oberer Teil der Durchgangsleitung (5) von der geätzten Oberfläche der isolierenden Schicht um eine vorbestimmte Höhe vorsteht; und
(g) Bilden einer zweiten elektrisch leitenden Schicht (8; 8, 9) über der isolierenden Schicht (7-1) und über den vorstehenden Teil der Durchgangsleitung (5).

2. Verfahren nach Anspruch 1, worin die erste elektrisch leitende Schicht gebildet wird durch:
(a1) Bilden einer ersten elektrisch leitenden Schicht (2) auf einem isolierenden Substrat (1),
(a2) Bilden eines ersten elektrisch leitenden Musters (3) auf der ersten elektrisch leitenden Schicht (2) ;
wobei die Resist-Schicht (4) über der ersten elektrisch leitenden Schicht (2) und über dem ersten elektrisch leitenden Muster (3) gebildet wird, wobei das Durchgangsloch (4A) auf dem ersten Muster (3) angeordnet wird;
wobei die erste elektrisch leitende Schicht (2) als eine Leitung für die Plattierung benutzt wird, um die Durchgangsleitung (5) zu bilden;
und worin ein vorbestimmter Teil der ersten elektrisch leitenden Schicht (2) entfernt wird, bevor die isolierende Schicht (7-1) gebildet wird, mit der das gesamte Substrat (1), das erste elektrisch leitende Muster (3) und die Durchgangsleitung (5) überzogen werden.

3. Verfahren nach Anspruch 1, worin die erste elektrisch leitende Schicht gebildet wird durch:
(a1) Bilden eines ersten elektrisch leitenden Musters auf einem isolierenden Substrat, welches ein Durchgangsloch aufweist, welches beide Seiten des Substrates elektrisch verbindet;
wobei die Resist-Schicht über dem Substrat und über dem ersten elektrisch leitenden Muster gebildet wird, wobei das Durchgangsloch auf dem ersten Muster angeordnet wird;
wobei das Durchgangsloch im Substrat als eine Leitung für die Plattierung benutzt wird;
wobei das gesamte Substrat, das erste elektrisch leitende Muster und die Durchgangsleitung mit der isolierenden Schicht überzogen werden.

4. Verfahren nach Anspruch 1, worin die erste elektrisch leitende Schicht gebildet wird durch:
(a1) Bilden eines ersten elektrisch leitenden Musters auf einem isolierenden Substrat;
(a2) Bilden einer ersten elektrisch leitenden Schicht auf dem ersten elektrisch leitenden Muster;
wobei die Resist-Schicht über der ersten elektrisch leitenden Schicht gebildet wird, wobei das Durchgangsloch auf dem ersten Muster angeordnet wird;
wobei die erste elektrisch leitende Schicht als eine Leitung für die Plattierung benutzt wird, um die Durchgangsleitung zu bilden;
und worin ein vorbestimmter Teil der ersten elektrisch leitenden Schicht entfernt wird, vor Bildung der isolierenden Schicht, mit der das gesamte Substrat, ein Restteil der ersten elektrisch leitenden Schicht und die Durchgangsleitung überzogen werden.

5. Verfahren nach einem der vorherigen Ansprüche, worin die isolierende Schicht (7-1) aus einem Harz, zum Beispiel einem organischen Harz, gebildet wird.

6. Verfahren nach einem der vorherigen Ansprüche, worin die isolierende Schicht Polyimid ist.

7. Verfahren nach einem der vorherigen Ansprüche, worin die isolierendn Schicht einen thermischen Ausdehnungskoeffizienten aufweist, der im Wesentlichen gleich dem thermischen Ausdehnungskoeffizienten des Materials der Durchgangsleitung ist.

8. Verfahren nach einem der vorherigen Ansprüche, worin die isolierende Schicht wesentlich dünner am Oberteil der Durchgangsleitung gebildet ist als auf anderen flachen Teilen.

9. Verfahren nach einem der vorherigen Ansprüche, worin der Oberflächenteil der isolierenden Schicht durch ein chemisches Ätzen entfernt wird.

10. Verfahren nach einem der vorherigen Ansprüche, worin der Oberflächenteil der isolierenden Schicht durch eine reaktive ionische Ätzmethode oder eine Ionen-Fräsmethode entfernt wird.

11. Verfahren nach einem der vorherigen Ansprüche, worin die zweite elektrisch leitende Schicht ein elektrisch leitendes Muster ist, das zum Beispiel durch elektrisches Plattieren gebildet wird.

12. Verfahren nach einem der vorherigen Ansprüche, welches ferner umfasst:
Bilden einer weiteren isolierenden Schicht (7-2) über der zweiten elektrisch leitenden Schicht (8; 8, 9) und der isolierenden Schicht(7-1),
Wiederholen der Schritte (a) bis (g), um eine Struktur auf der zweiten isolierenden Schicht (7-2) bereitzustellen, die als ein isolierendes Substrat in den Wiederholungsschritten wirkt.

## Revendications

1. Procédé de fabrication d'une structure multicouche, comprenant les opérations suivantes :
(a) former une première disposition en couches électriquement conductrice (2, 3) ;
(b) produire une couche de résist (4) ayant un trou de traversée (4A), ledit trou de traversée étant placé sur ladite première disposition en couches électriquement conductrice ;
(c) former un conducteur de traversée (5) dans ledit trou de traversée en plaquant électriquement un métal dans celui-ci ;
(d) retirer ladite couche de résist (4) ;
(e) former une couche isolante (7-1) de matériau non photosensible sur ladite première disposition en couches électriquement conductrice (2, 3) et ledit conducteur de traversée (5) ;
(f) graver une partie de surface de ladite couche isolante (7-1) jusqu'à ce qu'une partie supérieure dudit conducteur de traversée (5) fasse saillie d'une hauteur prédéterminée par rapport à la surface gravée de ladite couche isolante ; et
(g) former une deuxième disposition en couches électriquement conductrice (8 ; 8, 9) sur ladite couche (7-1) et sur la partie saillante dudit conducteur de traversée (5).

2. Procédé selon la revendication 1, où ladite première disposition en couches électriquement conductrice est formée par les opérations suivantes :
(a1) former une première couche électriquement conductrice (2) sur un substrat isolant (1),
(a2) former un premier motif électriquement conducteur (3) sur ladite première couche électriquement conductrice (2) ;
ladite couche de résist (4) étant formée sur ladite première couche électriquement conductrice (2) et sur ledit premier motif électriquement conducteur (3), ledit trou de traversée (4A) étant placé sur ledit premier motif (3) ;
ladite première couche électriquement conductrice (2) étant utilisée comme un conducteur destiné audit placage afin de former ledit conducteur de traversée (5) ;
et où une partie prédéterminée de ladite première couche électriquement conductrice (2) est retirée avant la formation de ladite couche isolante (7-1), que l'on revêt tout ensemble sur ledit substrat (1), ledit premier motif électriquement conducteur (3) et ledit conducteur de traversée (5).

3. Procédé selon la revendication 1, où ladite première disposition en couches électriquement conductrice est formée par l'opération suivante :
(a1) former un premier motif électriquement conducteur sur un substrat isolant ayant une traversée, ladite traversée connectant électriquement les deux côtés dudit substrat ;
ladite couche de résist étant formé sur ledit substrat et sur ledit premier motif électriquement conducteur, ledit trou de traversée étant placé sur ledit premier motif ;
ladite traversée ménagée dans le substrat étant utilisée comme conducteur pour ledit placage ;
ladite couche isolante étant déposée tout ensemble sur ledit substrat, ledit premier motif électriquement conducteur et ledit conducteur de traversée.

4. Procédé selon la revendication 1, où ladite première disposition en couches électriquement conductrice est formée par les opérations suivantes :
(a1) former un premier motif électriquement conducteur sur un substrat isolant ;
(a2) former une première couche électriquement conductrice sur ledit premier motif électriquement conducteur ;
ladite couche de résist étant formée sur ladite première couche électriquement conductrice, ledit trou de traversée étant placé sur ledit premier motif ;
ladite première couche électriquement conductrice étant utilisée comme conducteur pour ledit placage afin de former ledit conducteur de traversée ;
et où une partie prédéterminée de ladite première couche électriquement conductrice est retirée avant la formation de ladite couche isolante, qui est déposée tout ensemble sur ledit substrat, une partie résiduelle de ladite première couche électriquement conductrice et ledit conducteur de traversée.

5. Procédé selon l'une quelconque des revendications précédentes, où ladite couche isolante (7-1) est formée d'une résine, par exemple une résine organique.

6. Procédé selon l'une quelconque des revendications précédentes, où ladite couche isolante est faite de polyimide.

7. Procédé selon l'une quelconque des revendications précédentes, où ladite couche isolante possède un coefficient de dilatation thermique sensiblement égal au coefficient de dilatation thermique du matériau dudit conducteur de traversée.

8. Procédé selon l'une quelconque des revendications précédentes, où ladite couche isolante est formée de manière à être sensiblement plus mince sur le dessus dudit conducteur de traversée que sur d'autres parties, planes.

9. Procédé selon l'une quelconque des revendications précédentes, où la partie de surface de ladite couche isolante est retirée par gravure chimique.

10. Procédé selon l'une quelconque des revendications précédentes, où la partie de surface de ladite couche isolante est retirée par un procédé de gravure par ions réactifs ou par un procédé d'usinage par ions.

11. Procédé selon l'une quelconque des revendications précédentes, où ladite deuxième disposition en couches électriquement conductrice est un motif électriquement conducteur, formé par exemple par placage électrique.

12. Procédé selon l'une quelconque des revendications précédentes, comprenant en outre les opérations suivantes :
former une couche isolante supplémentaire (7-2) sur ladite deuxième disposition en couches électriquement conductrice (8 ; 8, 9) et ladite couche isolante (7-1),
répéter lesdites opérations (a) à (g) afin de produire une structure sur ladite deuxième couche isolante (7-2), qui agit comme un substrat isolant au cours des opérations de répétition.
